(19) **Europäisches Patentamt**

**European Patent Office**

**Office européen des brevets**

(11) **EP 1 264 685 A1**

(12) **EUROPEAN PATENT APPLICATION**
published in accordance with Art. 158(3) EPC

(43) Date of publication:
**11.12.2002 Bulletin 2002/50**

(51) Int Cl.⁷: **B32B 27/32**

(21) Application number: **01967729.3**

(86) International application number:
**PCT/JP01/08143**

(22) Date of filing: **19.09.2001**

(87) International publication number:
**WO 02/024449 (28.03.2002 Gazette 2002/12)**

(84) Designated Contracting States:
**DE**

(30) Priority: **20.09.2000 JP 2000285745**
**30.11.2000 JP 2000365003**

(71) Applicant: **Mitsui Chemicals, Inc.**
**Tokyo 100-6070 (JP)**

(72) Inventors:
• **NAKAHARA, Takashi**
**c/o MITSUI CHEMICALS, INC.**
**Kuga-gun, Yamaguchi 740-0061 (JP)**

• **IMUTA, Shinichi c/o MITSUI CHEMICALS, INC.**
**Kuga-gun, Yamaguchi 740-0061 (JP)**
• **SHIGEMOTO, Hiromi**
**c/o MITSUI CHEMICALS, INC.**
**Kuga-gun, Yamaguchi 740-0061 (JP)**

(74) Representative: **HOFFMANN - EITLE**
**Patent- und Rechtsanwälte**
**Arabellastrasse 4**
**81925 München (DE)**

(54) **MULTILAYERED 4-METHYL-1-PENTENE COPOLYMER FILM AND PROCESS FOR PRODUCING THE SAME**

(57)     The 4-methyl-1-pentene copolymer multi-layer film according to the present invention is a three-layer laminate or a five-layer laminate, which comprises a layer (A) comprising 4-methyl-1-pentene, a layer (B) comprising polypropylene or polyethylene, and optionally, a layer (C) comprising an adhesive resin, said layer (A) being provided on each surface of the layer (B) in the three-layer laminate or being provided on each surface of the layer (B) through the layer (C) in the five-layer laminate, and this multi-layer film is uniaxially stretched in a stretch ratio of not less than 2 times or biaxially oriented in a stretch ratio of not less than 1.5 times in each of the machine direction and the transverse direction. The process for producing a 4-methytl-1-pentene copol-

ymer multi-layer film according to the present invention comprises uniaxially stretching the three-layer laminate or the five-layer laminate in a stretch ratio of not less than 2 times, or comprises biaxially orienting the three-layer laminate or the five-layer laminate in a stretch ratio of not less than 1.5 times in each of the machine direction and the transverse direction. The multi-layer film of the invention has high rigidity and excellent releasability from a black oxidated copper foil, and is suitable as a release film for MLB production. In the process for producing a multi-layer film according to the invention, stretching unevenness and breaks hardly occur in the stretching operation and the productivity is good.

EP 1 264 685 A1

## Description

### FIELD OF THE INVENTION

The present invention relates to a 4-methyl-1-pentene copolymer multi-layer film and a process for producing the same. More particularly, the present invention relates to a 4-methyl-1-pentene copolymer multi-layer film that is useful as, for example, a release film and a process for producing the same.

### BACKGROUND OF THE INVENTION

It is well known that in recent years integration degree of IC is increased with rapid development of electronic equipments, and with the increase of integration degree, a great number of printed wiring boards have been used for the purpose of meeting requirements of high accuracy, high precision and high reliability.

The printed wiring boards include single-sided printed wiring boards, double-sided printed wiring boards, multi-layer printed wiring boards and flexible printed wiring boards. Above all, an applicable field of the multi-layer printed wiring board (abbreviated to "MLB" hereinafter) is spreading because it is possible to unite conductors of three or more layers with interposing insulating layers between the conductor layers and to connect arbitrary conductors with each other or an electrical part to be mounted with an arbitrary conductor layer.

The MLB is fabricated by, for example, a process comprising laminating a pair of single-sided or double-sided copper clad laminates as both side outer layers with interposing therebetween an internal circuit board of one or more layers through prepreg (epoxy resin or the like), holding them with a holding means, hot pressing them by means of press hot plates through cushioning materials to cure the prepreg and thereby form a firmly united laminate, hole drilling, through-hole plating, etc., and then etching the surface.

In the fabrication of the MLB, a release film is usually used between the copper clad laminate (outer layer) and the holding means. For the release film, a high heat-resistant resin that is not molten in the hot pressing process, such as a 4-methyl-1-pentene copolymer, polytetrafluoroethylene, acetate, polyester or polypropylene, is employed.

By the way, as a copper foil of the copper clad laminate, a so-called black oxidated copper foil, which has been oxidized and surface-roughened to enhance adhesion properties to an epoxy resin, is frequently used. In this case, there sometimes arises a problem that because of shortage in rigidity of the release film, the surface of the film intrudes into the black oxidated surface of the copper foil in the hot pressing process and therefore the release film cannot be released from the copper foil.

Under such circumstances, it has been proposed to use, as a release film, a film of high rigidity obtained by uniaxially stretching a 4-methyl-1-pentene copolymer film (see Japanese Patent Laid-Open Publication No. 73558/1991). The 4-methyl-1-pentene copolymer film, however, is liable to suffer stretching unevenness or breaks in the uniaxial stretching and is not good in productivity. Further, the film obtained by uniaxially stretching the 4-methyl-1-pentene copolymer film is sometimes insufficient in the releasability from the black oxidated copper foil surface.

Accordingly, the present inventors have studied a 4-methyl-1-pentene copolymer film hardly suffering stretching unevenness and breaks in the uniaxial stretching, having high rigidity after stretching and suitable for MLB production, and a process for producing the film, as well as the film having good releasability from the black oxidated copper foil and suitable for MLB production, and a process for producing the same.

As a result, the present inventors have found that a uniaxial stretched film, which has little stretching unevenness and few breaks brought about in the stretching, shows high rigidity and is favorable as a release film for MLB production, can be obtained by stretching a laminate comprising a 4-methyl-1-pentene copolymer and polyethylene or polypropylene.

The present inventors have also found that a biaxial oriented film, which has little stretching unevenness and few breaks brought about in the stretching, shows high rigidity and is favorable as a release film for MLB production that has excellent releasability from a black oxidated copper foil, can be obtained by biaxially orienting a laminate comprising a layer of a 4-methyl-1-pentene copolymer and a layer of polyethylene or polypropylene, in a stretch ratio of not less than 1.5 times in each of the machine direction and the transverse direction. Based on the above findings, the present invention has been accomplished.

That is to say, it is an object of the present invention to provide a 4-methyl-1-pentene copolymer multi-layer film of excellent rigidity, which is excellent in the releasability from a black oxidated copper foil when it is used as, for example, a release film for MLB production, and a process for producing the film.

### DISCLOSURE OF THE INVENTION

The first 4-methyl-1-pentene copolymer multi-layer film according to the invention is a three-layer laminate comprising:

(A) a layer comprising a 4-methyl-1-pentene copolymer (a) obtained from 4-methyl-1-pentene and an α-olefin of 2 to 20 carbon atoms other than 4-methyl-1-pentene, and

(B) a layer comprising polypropylene (b1) or polyethylene (b2),

said layer (A) being provided on each surface of the layer (B); and

is uniaxially stretched in a stretch ratio of not less than 2 times.

The other embodiment of the first 4-methyl-1-pentene copolymer multi-layer film according to the invention is a five-layer laminate comprising:

(A) a layer comprising a 4-methyl-1-pentene copolymer (a) obtained from 4-methyl-1-pentene and an α-olefin of 2 to 20 carbon atoms other than 4-methyl-1-pentene,

(B) a layer comprising polypropylene (b1) or polyethylene (b2), and

(C) a layer comprising an adhesive resin (c), said layer (A) being provided on each surface of the layer (B) through the layer (C); and

is uniaxially stretched in a stretch ratio of not less than 2 times.

The second 4-methyl-1-pentene copolymer multi-layer film according to the invention is a three-layer laminate comprising:

(A) a layer comprising a 4-methyl-1-pentene copolymer (a) obtained from 4-methyl-1-pentene and an α-olefin of 2 to 20 carbon atoms other than 4-methyl-1-pentene, and

(B) a layer comprising polypropylene (b1) or polyethylene (b2),

said layer (A) being provided on each surface of the layer (B); and

is biaxially oriented in a stretch ratio of not less than 1.5 times in each of the machine direction and the transverse direction.

The other embodiment of the second 4-methyl-1-pentene copolymer multi-layer film according to the invention is a five-layer laminate comprising:

(A) a layer comprising a 4-methyl-1-pentene copolymer (a) obtained from 4-methyl-1-pentene and an α-olefin of 2 to 20 carbon atoms other than 4-methyl-1-pentene,

(B) a layer comprising polypropylene (b1) or polyethylene (b2), and

(C) a layer comprising an adhesive resin (c),

said layer (A) being provided on each surface of the layer (B) through the layer (C); and

is biaxially oriented in a stretch ratio of not less than 1.5 times in each of the machine direction and the transverse direction.

In the first and the second 4-methyl-1-pentene copolymer multi-layer films according to the invention, the 4-methyl-1-pentene copolymer (a) preferably contains recurring units derived from 4-methyl-1-pentene in amounts of not less than 93 % by weight.

The adhesive resin (c) employable in the first and the second 4-methyl-1-pentene copolymer multi-layer films according to the invention is, for example, an adhesive resin comprising poly-4-methyl-1-pentene (d) and poly-1-butene (e) and containing the poly-4-methyl-1-pentene (d) and the poly-1-butene (e) in a weight ratio (d:e) of 95:5 to 50:50.

The first and the second 4-methyl-1-pentene copolymer multi-layer films according to the invention preferably have a tensile modulus of not less than 1500 MPa.

The first and the second 4-methyl-1-pentene copolymer multi-layer films according to the invention are each preferably used as a release film.

The first process for producing a 4-methyl-1-pentene copolymer multi-layer film according to the invention comprises uniaxially stretching a three-layer laminate in a stretch ratio of not less than 2 times, said three-layer laminate comprising:

(A) a layer comprising a 4-methyl-1-pentene copolymer (a) obtained from 4-methyl-1-pentene and an α-olefin of 2 to 20 carbon atoms other than 4-methyl-1-pentene, and

(B) a layer comprising polypropylene (b1) or polyethylene (b2),

said layer (A) being provided on each surface of the layer (B).

The other embodiment of the first process for producing a 4-methyl-1-pentene copolymer multi-layer film according to the invention comprises uniaxially stretching a five-layer laminate in a stretch ratio of not less than 2 times, said five-layer laminate comprising:

(A) a layer comprising a 4-methyl-1-pentene copolymer (a) obtained from 4-methyl-1-pentene and an $\alpha$-olefin of 2 to 20 carbon atoms other than 4-methyl-1-pentene,
(B) a layer comprising polypropylene (b1) or polyethylene (b2), and
(C) a layer comprising an adhesive resin (c),
said layer (A) being provided on each surface of the layer (B) through the layer (C).

The second process for producing a 4-methyl-1-pentene copolymer multi-layer film according to the invention comprises biaxially orienting a three-layer laminate in a stretch ratio of not less than 1.5 times in each of the machine direction and the transverse direction, said three-layer laminate comprising:

(A) a layer comprising a 4-methyl-1-pentene copolymer (a) obtained from 4-methyl-1-pentene and an $\alpha$-olefin of 2 to 20 carbon atoms other than 4-methyl-1-pentene, and
(B) a layer comprising polypropylene (b1) or polyethylene (b2),
said layer (A) being provided on each surface of the layer (B).

The other embodiment of the second process for producing a 4-methyl-1-pentene copolymer multi-layer film according to the invention comprises biaxially orienting a five-layer laminate in a stretch ratio of not less than 1.5 times in each of the machine direction and the transverse direction, said five-layer laminate comprising:

(A) a layer comprising a 4-methyl-1-pentene copolymer (a) obtained from 4-methyl-1-pentene and an $\alpha$-olefin of 2 to 20 carbon atoms other than 4-methyl-1-pentene,
(B) a layer comprising polypropylene (b1) or polyethylene (b2), and
(C) a layer comprising an adhesive resin (c),
said layer (A) being provided on each surface of the layer (B) through the layer (C).

## PREFERRED EMBODIMENTS OF THE INVENTION

The 4-methyl-1-pentene copolymer multi-layer film and a process for producing the film according to the present invention are described in detail hereinafter.

First 4-methyl-1-pentene copolymer multi-layer film

The first 4-methyl-1-pentene copolymer multi-layer film according to the invention is a three-layer laminate or a five-layer laminate comprising:

(A) a layer comprising a 4-methyl-1-pentene copolymer (a),
(B) a layer comprising polypropylene (b1) or polyethylene (b2),
        and optionally
(C) a layer comprising an adhesive resin (c),
said layer (A) being provided on each surface of the layer (B) in the three-layer laminate or being provided on each surface of the layer (B) through the layer (C) in the five-layer laminate; and
is uniaxially stretched in a stretch ratio of not less than 2 times.

First, resins for forming the first 4-methyl-1-pentene copolymer multi-layer film according to the invention are described.

4-Methyl-1-pentene copolymer (a)

The 4-methyl-1-pentene copolymer (a) for use in the present invention is a copolymer of 4-methyl-1-pentene and an $\alpha$-olefin of 2 to 20 carbon atoms other than 4-methyl-1-pentene.
Examples of the $\alpha$-olefins of 2 to 20 carbon atoms other than 4-methyl-1-pentene include ethylene, propylene, 1-butene, 1-hexene, 1-heptene, 1-octene, 1-decene, 1-tetradecene, 1-hexadecene, 1-heptadecene, 1-octadecene and 1-eicosene. The $\alpha$-olefins other than 4-methyl-1-pentene can be used singly or in combination of two or more kinds. Of these, an $\alpha$-olefin of 7 to 20 carbon atoms, preferably 8 to 20 carbon atoms, more preferably 10 to 20 carbon atoms, is preferable.
The 4-methyl-1-pentene copolymer (a) desirably contains recurring units derived from 4-methyl-1-pentene in amounts of usually not less than 93 % by weight, preferably 93 to 97 % by weight, more preferably 94 to 96 % by weight, and recurring units derived from the α-olefin in amounts of usually not more than 7 % by weight, preferably 3 to 7 % by weight, more preferably 4 to 6 % by weight. When the amounts of the recurring units derived from an α-olefin of 2 to 20 carbon atoms other than 4-methyl-1-pentene are in the above range, the 4-methyl-1-pentene copolymer (a) has excellent moldability and rigidity.

The 4-methyl-1-pentene copolymer (a) has a melt flow rate (MFR), as measured under the conditions of a load of 5.0 kg and a temperature of 260°C in accordance with ASTM D 1238, of usually 0.5 to 250 g/10 min, preferably 1.0 to 150 g/10 min. When the MFR is in the above range, the 4-methyl-1-pentene copolymer (a) has excellent moldability and mechanical strength properties.

The 4-methyl-1-pentene copolymer (a) can be prepared by a hitherto known process.

To the 4-methyl-1-pentene copolymer (a), hitherto known additives usually added to polyolefins, such as heat stabilizer, weathering stabilizer, rust inhibitor, copper inhibitor and antistatic agent, can be added within limits not detrimental to the object of the invention.

The additives employable herein are, for example, the following compounds.

Examples of phenolic antioxidants include phenols, such as 2,6-di-tert-butyl-p-cresol and stearyl(3,3-dimethyl-4-hydroxybenzyl)thioglycolate; and polyphenol carbonic acid oligoesters, such as carbonic acid oilgoesters of 4,4'-butylidenebis(2-tert-butyl-5-methylphenol) (e.g., those having polymerization degree of 2, 3, 4, 5, 6, 7, 8, 9 or 10).

An example of a sulfur antioxidant is dialkyl thiodipropionate.

An example of a phosphorus antioxidant is triphenyl phosphite.

A complex compound represented by the following formula can be added as, for example, a hydrochloric acid absorbent.

$$M_xAl_y(OH)_{2x+3y-2z}(A)_z \cdot aH_2O$$

wherein M is Mg, Ca or Zn, A is an anion other than a hydroxyl group, x, y and z are each a positive number, and a is 0 or a positive number.

An example of a light stabilizer is 2-hydroxy-4-methoxybenzophenone.

Examples of lubricants include paraffin wax, polyethylene wax and calcium stearate.

These additives can be used in amounts of usually 0.0001 to 10 parts by weight based on 100 parts by weight of the 4-methyl-1-pentene copolymer (a).

Polypropylene (b1) or polyethylene (b2)

The polypropylene (b1) for use in the present invention is a homopolymer of propylene or a copolymer of propylene and at least one olefin selected from α-olefins of 2 to 20 carbon atoms other than propylene.

Examples of the α-olefins of 2 to 20 carbon atoms other than propylene include 1-butene, 1-pentene, 1-hexene, 4-methyl-1-pentene, 1-octene, 1-decene and mixtures thereof. Of these, an α-olefin of 4 to 10 carbon atoms is particularly preferably employed.

In the polypropylene (b1), the molar ratio (propylene/α-olefin other than propylene) of propylene to the α-olefin of 2 to 20 carbon atoms other than propylene is in the range of usually 100/0 to 90/10, preferably 100/0 to 95/5, though it varies depending upon the type of the α-olefin.

The polypropylene (b1) may contain component units other than those derived from an α-olefin, such as component units derived from a diene compound, within limits not detrimental to its characteristic. The content of the diene component is in the range of usually 0 to 1 % by mol, preferably 0 to 0.5 % by mol.

The polypropylene (b1) desirably has a melt flow rate (MFR), as measured at 230°C under a load of 2.16 kg, of 0.1 to 100 g/10 min, preferably 0.5 to 50 g/10 min, and a density of more than 0.900 g/cm$^3$, preferably 0.900 to 0.920 g/cm$^3$.

The polypropylene (b1) can be prepared by a hitherto known process.

The polyethylene (b2) for use in the present invention is a homopolymer of ethylene or a copolymer of ethylene and an α-olefin of 3 to 20 carbon atoms.

Examples of the α-olefins of 3 to 20 carbon atoms include propylene, 1-butene, 1-pentene, 1-hexene, 4-methyl-1-pentene, 1-octene, 1-decene and mixtures thereof. Of these, an α-olefin of 3 to 10 carbon atoms is particularly preferably employed.

The polyethylene (b2) may contain component units other than those derived from an α-olefin, such as component units derived from a diene compound, within limits not detrimental to its characteristic. The content of the diene component is in the range of usually 0 to 1 % by mol, preferably 0 to 0.5 % by mol.

In the polyethylene (b2), the molar ratio (ethylene/α-olefin) of ethylene to the α-olefin of 3 to 20 carbon atoms is in the range of usually 100/0 to 99/1, preferably 100/0 to 99.5/0.5, though it varies depending upon the type of the α-olefin.

The polyethylene (b2) desirably has a melt flow rate (MFR), as measured at 190°C under a load of 2.16 kg, of 0.01 to 100 g/10 min, preferably 0.05 to 50 g/10 min, and a density of more than 0.900 g/cm$^3$, preferably 0.930 to 0.970 g/cm$^3$.

The polypropylene (b2) can be prepared by a hitherto known process.

Adhesive resin (c)

The adhesive resin (c) for use in the present invention is not specifically restricted as long as the resin is capable of bonding the layer (A) comprising the 4-methyl-1-pentene copolymer (a) to the layer (B) comprising the polypropylene (b1) or the polyethylene (b2), but the adhesive resin (c) preferably used in the invention is, for example, an adhesive resin composition comprising poly-4-methyl-1-pentene (d) and poly-1-butene (e).

The poly-4-methyl-1-pentene (d) for forming the adhesive resin composition is a homopolymer of 4-methyl-1-pentene or a copolymer of 4-methyl-1-pentene and an α-olefin of 2 to 20 carbon atoms other than 4-methyl-1-pentene.

Examples of the α-olefins of 2 to 20 carbon atoms other than 4-methyl-1-pentene include ethylene, propylene, 1-butene, 1-hexene, 1-octene, 1-decene, 1-tetradecene, 1-octadecene, 1-hexadecene, 1-dodecene, 1-tetradodecene and 1-eicosene. These α-olefins can be used singly or in combination of two or more kinds. Of these, preferable is 1-hexene, 1-decene, 1-tetradecene, 1-octadecene, 1-dodecene, 1-tetradodecene or 1-eicosene.

In the poly-4-methyl-1-pentene (d), recurring units derived from 4-methyl-1-pentene are contained in amounts of usually 100 to 80 % by mol and recurring units derived from the α-olefin of 2 to 20 carbon atoms are contained in amounts of usually 0 to 20 % by mol. It is preferable that the recurring units derived from 4-methyl-1-pentene are contained in amounts of 99.9 to 80 % by mol and the recurring units derived from the α-olefin of 2 to 20 carbon atoms are contained in amounts of 0.1 to 20 % by mol.

The poly-4-methyl-1-pentene (d) has MFR of usually 0.1 to 200 g/10 min, preferably 1.0 to 150 g/10 min.

The poly-1-butene (e) for forming the adhesive resin composition is a homopolymer of 1-butene or a copolymer of 1-butene and an α-olefin of 2 to 20 carbon atoms other than 1-butene.

Examples of the α-olefins of 2 to 20 carbon atoms other than 1-butene include ethylene, propylene, 1-hexene, 1-octene, 1-decene, 1-tetradecene and 1-octadecene. These α-olefins can be used singly or in combination of two or more kinds. Of these, preferable is ethylene or propylene.

The poly-1-butene (e) is a copolymer containing recurring units derived from 1-butene in amounts of not less than 60 % by weight. Especially when the recurring units derived from 1-butene are contained in amounts of not less than 80 % by weight, the poly-1-butene (e) has excellent compatibility with the poly-4-methyl-1-pentene (d).

The poly-1-butene (e) has MFR, as measured under the conditions of a load of 2.16 kg and a temperature of 190°C in accordance with ASTM D 1238, of usually 0.01 to 100 g/10 min, preferably 0.1 to 50 g/10 min.

When the MFR of the poly-1-butene (e) is in the above range, the poly-1-butene (e) has excellent blendability with the poly-4-methyl-1-pentene (d), and thereby the adhesive resin composition exhibits high adhesion properties.

In the adhesive resin composition, the weight ratio (d:e) of the poly-4-methyl-1-pentene (d) to the poly-1-butene (e) is in the range of usually 95:5 to 50:50, preferably 80:20 to 60:40. When the weight ratio (d:e) of the poly-4-methyl-1-pentene (d) to the poly-1-butene (e) is in the above range, the composition exhibits high adhesion properties.

The adhesive resin composition can be prepared by, for example, melt kneading the poly-4-methyl-1-pentene (d) with the poly-1-butene (e) in accordance with a hitherto known method. For example, the adhesive resin composition can be prepared by mixing a given amount of the poly-4-methyl-1-pentene (d) with a given amount of the poly-1-butene (e) by a V-type blender, a ribbon blender, a Henschel mixer, a tumbling blender or the like, and then melt kneading the mixture by a single-screw extruder, a multi-screw extruder or the like, followed by pelletizing, or melt kneading the mixture by a kneader, a Banbury mixer or the like, followed by pulverization.

When the layer (C) comprising the adhesive resin (c) is formed from the above-described adhesive resin composition, the layer (A) and the layer (B) can be firmly bonded.

Multi-layer film

One embodiment of the first 4-methyl-1-pentene copolymer multi-layer film according to the present invention is a three-layer laminate, which comprises the layer (A) comprising the 4-methyl-1-pentene copolymer (a) and the layer (B) comprising the polypropylene (b1) or the polyethylene (b2) and has a structure of (A)/(B)/(A) wherein the layer (A) is provided on each surface of the layer (B), and is uniaxially stretched in a stretch ratio of not less than 2 times, preferably 2 to 10 times, more preferably 3 to 8 times.

Although the thickness of the 4-methyl-1-pentene copolymer multi-layer film is not specifically restricted, it is in the range of usually about 5 to 500 μm, preferably about 10 to 200 μm. Although the thickness of each layer to constitute the 4-methyl-1-pentene copolymer multi-layer film is not specifically restricted, one layer (A) has a thickness of usually 1 to 100 μm, preferably 5 to 50 μm, the layer (B) has a thickness of usually 3 to 100 μm, preferably 10 to 50 μm, and the other layer (A) has a thickness of usually 1 to 100 μm, preferably 5 to 50 μm.

The 4-methyl-1-pentene copolymer multi-layer film has a tensile modulus of usually not less than 1500 MPa, preferably 1500 to 4000 MPa, more preferably 1700 to 3000 MPa.

When the tensile modulus of the 4-methyl-1-pentene copolymer multi-layer film is in the above range, adhesive transfer hardly takes place.

Measurement of the tensile modulus is carried out in the following manner. A rectangular test strip having a width of 1.27 cm and a length of 6.35 cm cut from a 4-methyl-1-pentene copolymer multi-layer film is measured by the use of an Instron tensile tester model 4501 under the conditions of a temperature of 23°C and a crosshead speed of 5 mm/min.

The other embodiment of the first 4-methyl-1-pentene copolymer multi-layer film according to the invention is a five-layer laminate, which comprises the layer (A) comprising the 4-methyl-1-pentene copolymer (a), the layer (B) comprising the polypropylene (b1) or the polyethylene (b2) and the layer (C) comprising the adhesive resin (c) and has a structure of (A)/(C)/(B)/(C)/(A) wherein the layer (A) is provided on each surface of the layer (B) through the layer (C), and is uniaxially stretched in a stretch ratio of not less than 2 times, preferably 2 to 10 times, more preferably 3 to 8 times.

Although the thickness of the 4-methyl-1-pentene copolymer multi-layer film is not specifically restricted, it is in the range of usually about 5 to 500 μm, preferably about 10 to 200 μm. Although the thickness of each layer to constitute the 4-methyl-1-pentene copolymer multi-layer film is not specifically restricted, one layer (A) has a thickness of usually 1 to 100 μm, preferably 5 to 50 μm, one layer (C) has a thickness of usually 1 to 100 μm, preferably 5 to 50 μm, the layer (B) has a thickness of usually 3 to 100 μm, preferably 10 to 50 μm, the other layer (C) has a thickness of usually 1 to 100 μm, preferably 5 to 50 μm, and the other layer (A) has a thickness of usually 1 to 100 μm, preferably 5 to 50 μm.

The 4-methyl-1-pentene copolymer multi-layer film has a tensile modulus of usually not less than 1500 MPa, preferably 1500 to 4000 MPa, more preferably 1700 to 3000 MPa.

When the tensile modulus of the 4-methyl-1-pentene copolymer multi-layer film is in the above range, adhesive transfer hardly takes place.

The first 4-methyl-1-pentene copolymer multi-layer film of the invention described above is excellent in rigidity and releasability. For example, owing to the excellent releasability from a black oxidated copper foil, the 4-methyl-1-pentene copolymer multi-layer film is favorable as a release film, particularly as a release film for MLB production.


Second 4-methyl-1-pentene copolymer multi-layer film

The second 4-methyl-1-pentene copolymer multi-layer film according to the present invention is a three-layer laminate or a five-layer laminate comprising:

(A) a layer comprising a 4-methyl-1-pentene copolymer (a),
(B) a layer comprising polypropylene (b1) or polyethylene (b2),
    and optionally
(C) a layer comprising an adhesive resin (c),
said layer (A) being provided on each surface of the layer (B) in the three-layer laminate or being provided on each surface of the layer (B) through the layer (C) in the five-layer laminate; and
is biaxially oriented in a stretch ratio of not less than 1.5 times in each of the machine direction and the transverse direction.

The 4-methyl-1-pentene copolymer (a) for use in the invention is the same as the 4-methyl-1-pentene copolymer (a) for use in the aforesaid first 4-methyl-1-pentene copolymer multi-layer film. To the 4-methyl-1-pentene copolymer (a), the same additives as previously exemplified for the 4-methyl-1-pentene copolymer (a) for use in the aforesaid first 4-methyl-1-pentene copolymer multi-layer film can be added in the same amounts as previously described.

The polypropylene (b1) for use in the invention is the same as the polypropylene (b1) for use in the aforesaid first 4-methyl-1-pentene copolymer multi-layer film. The polyethylene (b2) for use in the invention is the same as the polyethylene (b2) for use in the aforesaid first 4-methyl-1-pentene copolymer multi-layer film.

The adhesive resin (c) for use in the invention is not specifically restricted as long as the resin is capable of bonding the layer (A) comprising the 4-methyl-1-pentene copolymer (a) to the layer (B) comprising the polypropylene (b1) or the polyethylene (b2), but the adhesive resin (c) preferably used in the invention is, for example, such an adhesive resin composition comprising poly-4-methyl-1-pentene (d) and poly-1-butene (e) as used in the aforesaid first 4-methyl-1-pentene copolymer multi-layer film.

When the layer (C) comprising the adhesive resin (c) is formed from the aforesaid adhesive resin composition, the layer (A) and the layer (B) can be firmly bonded.

Multi-layer film

One embodiment of the second 4-methyl-1-pentene copolymer multi-layer film according to the present invention is a three-layer laminate, which comprises the layer (A) comprising the 4-methyl-1-pentene copolymer (a) and the layer (B) comprising the polypropylene (b1) or the polyethylene (b2) and has a structure of (A)/(B)/(A) wherein the layer (A) is provided on each surface of the layer (B), and is biaxially oriented in a stretch ratio of not less than 1.5 times, preferably 3 to 10 times, more preferably 4 to 8 times, in each of the machine direction and the transverse direction.

Although the thickness of the 4-methyl-1-pentene copolymer multi-layer film is not specifically restricted, it is in the range of usually about 5 to 500 μm, preferably about 10 to 200 μm. Although the thickness of each layer to constitute the 4-methyl-1-pentene copolymer multi-layer film is not specifically restricted, one layer (A) has a thickness of usually 1 to 100 μm, preferably 5 to 50 μm, the layer (B) has a thickness of usually 3 to 100 μm, preferably 10 to 50 μm, and the other layer (A) has a thickness of usually 1 to 100 μm, preferably 5 to 50 μm.

The 4-methyl-1-pentene copolymer multi-layer film has a tensile modulus of usually not less than 1500 MPa, preferably 1500 to 4000 MPa, more preferably 1700 to 3000 MPa.

When the tensile modulus of the 4-methyl-1-pentene copolymer multi-layer film is in the above range, adhesive transfer hardly takes place.

The other embodiment of the second 4-methyl-1-pentene copolymer multi-layer film according to the invention is a five-layer laminate, which comprises the layer (A) comprising the 4-methyl-1-pentene copolymer (a), the layer (B) comprising the polypropylene (b1) or the polyethylene (b2) and the layer (C) comprising the adhesive resin (c) and has a structure of (A)/(C)/(B)/(C)/(A) wherein the layer (A) is provided on each surface of the layer (B) through the layer (C), and is biaxially oriented in a stretch ratio of not less than 1.5 times, preferably 3 to 10 times, more preferably 4 to 8 times, in each of the machine direction and the transverse direction.

Although the thickness of the 4-methyl-1-pentene copolymer multi-layer film is not specifically restricted, it is in the range of usually about 5 to 500 μm, preferably about 10 to 200 μm. Although the thickness of each layer to constitute the 4-methyl-1-pentene copolymer multi-layer film is not specifically restricted, one layer (A) has a thickness of usually 1 to 100 μm, preferably 5 to 50 μm, one layer (C) has a thickness of usually 1 to 100 μm, preferably 5 to 50 μm, the layer (B) has a thickness of usually 3 to 100 μm, preferably 10 to 50 μm, the other layer (C) has a thickness of usually 1 to 100 μm, preferably 5 to 50 μm, and the other layer (A) has a thickness of usually 1 to 100 μm, preferably 5 to 50 μm.

The 4-methyl-1-pentene copolymer multi-layer film has a tensile modulus of usually not less than 1500 MPa, preferably 1500 to 4000 MPa, more preferably 1700 to 3000 MPa.

When the tensile modulus of the 4-methyl-1-pentene copolymer multi-layer film is in the above range, adhesive transfer hardly takes place.

The second 4-methyl-1-pentene copolymer multi-layer film of the invention described above is excellent in rigidity and releasability. For example, owing to the excellent releasability from a black oxidated copper foil, the 4-methyl-1-pentene copolymer multi-layer film is favorable as a release film, particularly as a release film for MLB production.

First process for producing 4-methyl-1-pentene copolymer multi-layer film

The first process for producing a 4-methyl-1-pentene copolymer multi-layer film according to the present invention comprises forming the layer (A) of the 4-methyl-1-pentene copolymer (a) and the layer (B) of the polypropylene (b1) or the polyethylene (b2) from the 4-methyl-1-pentene copolymer (a) and the polypropylene (b1) or the polyethylene (b2), respectively, to produce a three-layer laminate having a structure of (A)/(B)/(A) and then uniaxially stretching the three-layer laminate in a stretch ratio of not less than 2 times. Through this process, a three-layer film of the first 4-methyl-1-pentene copolymer multi-layer films can be produced.

The three-layer laminate is produced by, for example, coextrusion molding of the 4-methyl-1-pentene copolymer (a) and the polypropylene (b1) or the polyethylene (b2), or press molding of sheets or films which have been previously formed from the above resins by press molding, extrusion molding or the like.

Although the thickness of the three-layer laminate is not specifically restricted, it is in the range of preferably about 10 to 2000 μm. Although the thickness of each layer to constitute the three-layer laminate is not specifically restricted, one layer (A) has a thickness of preferably 2 to 1000 μm, the layer (B) has a thickness of preferably 6 to 1000 μm, and the other layer (A) has a thickness of preferably 2 to 1000 μm.

The three-layer laminate obtained as above is uniaxially stretched by a hitherto known method, whereby the 4-methyl-1-pentene copolymer multi-layer film of the invention is obtained. The heating,temperature for uniaxially stretching the three-layer laminate is in the range of usually 120 to 210°C, preferably 160 to 180°C.

The stretch ratio in the uniaxial stretching of the three-layer laminate is usually not less than 2 times, preferably 2 to 10 times, more preferably about 3 to 8 times.

The other embodiment of the first process for producing a 4-methyl-1-pentene copolymer multi-layer film according to the invention comprises forming the layer (A) of the 4-methyl-1-pentene copolymer (a), the layer (C) of the adhesive resin (c) and the layer (B) of the polypropylene (b1) or the polyethylene (b2) from the 4-methyl-1-pentene copolymer (a), the adhesive resin (c), and the polypropylene (b1) or the polyethylene (b2), respectively, to produce a five-layer laminate having a structure of (A)/(C)/(B)/(C)/(A) and then uniaxially stretching the five-layer laminate in a stretch ratio of not less than 2 times. Through this process, a five-layer film of the first 4-methyl-1-pentene copolymer multi-layer films can be produced.

The five-layer laminate is produced by, for example, coextrusion molding of the 4-methyl-1-pentene copolymer (a), the adhesive resin (c) and the polypropylene (b1) or the polyethylene (b2), or press molding of sheets or films which have been previously formed from the above resins by press molding, extrusion molding or the like.

Although the thickness of the five-layer laminate is not specifically restricted, it is in the range of preferably about 10 to 5000 μm. Although the thickness of each layer to constitute the five-layer laminate is not specifically restricted, one layer (A) has a thickness of preferably 2 to 2000 μm, one layer (C) has a thickness of preferably 2 to 2000 μm, the layer (B) has a thickness of preferably 6 to 2000 μm, the other layer (C) has a thickness of preferably 2 to 2000 μm, and the other layer (A) has a thickness of preferably 2 to 2000 μm.

The five-layer laminate obtained as above is uniaxially stretched by a hitherto known method, whereby the 4-methyl-1-pentene copolymer multi-layer film of the invention is obtained. The heating temperature for uniaxially stretching the five-layer laminate is in the range of usually 120 to 210°C, preferably 160 to 180°C.

The stretch ratio in the uniaxial stretching of the five-layer laminate is usually not less than 2 times, preferably 2 to 10 times, more preferably about 3 to 8 times.

According to the invention, a uniaxially stretched 4-methyl-1-pentene copolymer multi-layer film of three layers or five layers, which has little stretching unevenness and few breaks brought about in the stretching and shows high rigidity, can be obtained.

Second process for producing 4-methyl-1-pentene copolymer multi-layer film

In the second process for producing a 4-methyl-1-pentene copolymer multi-layer film according to the present invention, a three-layer laminate having a structure of (A)/(B)/(A), which is produced in the same manner as in the first process for producing a 4-methyl-1-pentene copolymer multi-layer film and has the same each layer thickness as described above, is biaxially oriented by a hitherto known method in a stretch ratio of not less than 1.5 times in each of the machine direction and the transverse direction. Through this process, a three-layer film of the second 4-methyl-1-pentene copolymer multi-layer films can be produced.

The heating temperature for biaxially orienting the three-layer laminate is in the range of usually 120 to 210°C, preferably 160 to 180°C.

The stretch ratio in the biaxial orientation of the three-layer laminate is usually not less than 1.5 times, preferably 3 to 10 times, more preferably about 4 to 8 times, in each of the machine direction and the transverse direction.

In the other embodiment of the second process for producing a 4-methyl-1-pentene copolymer multi-layer film according to the invention, a five-layer laminate having a structure of (A)/(C)/(B)/(C)/(A), which is produced in the same manner as in the first process for producing a 4-methyl-1-pentene copolymer multi-layer film and has the same each layer thickness as described above, is biaxially oriented by a hitherto known method in a stretch ratio of not less than 1.5 times in each of the machine direction and the transverse direction. Through this process, a five-layer film of the second 4-methyl-1-pentene copolymer multi-layer films can be produced.

The heating temperature for biaxially orienting the five-layer laminate is in the range of usually 120 to 210°C, preferably 160 to 180°C.

The stretch ratio in the biaxial orientation of the five-layer laminate is usually not less than 1.5 times, preferably 3 to 10 times, more preferably about 4 to 8 times, in each of the machine direction and the transverse direction.

According to the present invention, a biaxially oriented 4-methyl-1-pentene copolymer multi-layer film of three layers or five layers, which has little stretching unevenness and few breaks brought about in the stretching and shows high rigidity, can be obtained.

**EXAMPLES**

The present invention is further described with reference to the following examples, but it should be construed that the invention is in no way limited to those examples.

In the examples, the following materials were used as the 4-methyl-1-pentene copolymer, polypropylene and the adhesive resin.

4-Methyl-1-pentene copolymer (1)

Copolymer of 4-methyl-1-pentene and Diarene 168 (trade name, mixture of α-olefin of 16 carbon atoms and α-olefin of 18 carbon atoms, available from Mitsubishi Chemical Industries, Ltd.), 4-methyl-1-pentene content in this copolymer: 94 % by weight, total content of α-olefin of 16 carbon atoms and α-olefin of 18 carbon atoms: 6 % by weight, MFR (measured under a load of 5.0 kg at a temperature of 260°C in accordance with ASTM D 1238): 23 g/10 min

4-Methyl-1-pentene copolymer (2)

Copolymer of 4-methyl-1-pentene and Diarene 124 (trade name, mixture of α-olefin of 12 carbon atoms and α-olefin of 14 carbon atoms, available from Mitsubishi Chemical Industries, Ltd.), 4-methyl-1-pentene content in this copolymer: 95 % by weight, total content of α-olefin of 12 carbon atoms and α-olefin of 14 carbon atoms: 5 % by weight, MFR (measured under a load of 5.0 kg at a temperature of 260°C in accordance with ASTM D 1238): 23 g/10 min

Poly-4-methyl-1-pentene copolymer (3)

Copolymer of 4-methyl-1-pentene and 1-decene, 4-methyl-1-pentene content in this copolymer: 96 % by weight, 1-decene content: 4 % by weight, MFR (measured under a load of 5.0 kg at a temperature of 260°C in accordance with ASTM D 1238): 23 g/10 min

Poly-4-methyl-1-pentene copolymer (4)

Mixture of 50 % by weight of the 4-methyl-1-pentene copolymer (1) and 50 % by weight of the 4-methyl-1-pentene copolymer (3), MFR of this mixture (measured under a load of 5.0 kg at a temperature of 260°C in accordance with ASTM D 1238): 23 g/10 min

Polypropylene (b1)

Trade name: F-600, available from Grand Polymer K.K., density: 0.91 g/cm$^3$, MFR (measured under a load of 2.16 kg at a temperature of 230°C in accordance with ASTM D 1238): 10 g/10 min

Polyethylene (b2)

Trade name: Ultzex 2022L, available from Mitsui Chemicals, Inc., density: 0.91 g/cm$^3$, MFR (measured under a load of 2.16 kg at a temperature of 190°C in accordance with ASTM D 1238): 2.1 g/10 min

Adhesive resin (c)

Adhesive resin obtained by a process comprising blending 60 parts by weight of a 4-methyl-1-pentene copolymer (1-octadecene content: 6 % by weight, MFR = 3.0 g/10 min), 40 parts by weight of a 1-butene copolymer (ethylene content: 5 % by weight, MFR = 2.5 g/10 min), 0.10 part by weight of Irganox 1010 (trade name, available from Ciba K.K.) as a stabilizer and 0.03 part by weight of calcium stearate (available from Sankyo Yuki Gosei K.K.), then mixing them for 3 minutes by a Henschel mixer through low-speed revolution and extruding the mixture by a twin-screw extruder at a temperature of 280°C.

Example 1

An unstretched film of two-material three-layer type having a structure of 4-methyl-1-pentene copolymer (1) /polypropylene (b1)/4-methyl-1-pentene copolymer (1) (each layer thickness = 60/80/60 μm) was prepared by the use of a T-die extrusion molding machine. This unstretched film was examined on the stretchability.
Then, the unstretched film of two-material three-layer type was uniaxially stretched in a stretch ratio of 4 times to obtain a stretched film of 4-methyl-1-pentene copolymer (1)/polypropylene (b1)/4-methyl-1-pentene copolymer (1) (each layer thickness = 15/20/15 μm).
The stretching was carried out by cutting the unstretched film to give a square specimen having a length of 5 cm and a width of 5 cm and uniaxially stretching the specimen in a stretch ratio of 4 times at a temperature of 180°C and a rate of 5 m/min (the same shall apply to the following Examples 2 to 8 and Comparative Examples).

The stretched film thus obtained was examined on the releasability and rigidity. The results are set forth in Table 1.

In the examples, the stretchability and the releasability were evaluated in the following manner.

Stretchability

Five films were stretched, and the number of films having stretching unevenness and breaks was checked.

Releasability

A film was superposed on a surface of a copper foil, said surface having been subjected to black oxidation with sodium chlorite, and they were pressed under the conditions of 190°C, 20 kg and 30 minutes. Then, releasability of the film from the copper foil was examined. A film which had been completely released from the copper foil by a usual operation was evaluated as "good", while a film only a part of which had been released was measured on the area sticking to the copper foil, and a proportion of the measured area to the contact area with the copper foil based on the contact area being 100 % is set forth in the table.

Example 2

An unstretched film of two-material three-layer type having a structure of 4-methyl-1-pentene copolymer (3) /polypropylene (b1)/poly-4-methyl-1-pentene copolymer (3) (each layer thickness = 60/80/60 µm) was prepared by the use of a T-die extrusion molding machine. This unstretched film was examined on the stretchability.

Then, the unstretched film of two-material three-layer type was uniaxially stretched in a stretch ratio of 4 times to obtain a stretched film of 4-methyl-1-pentene copolymer (3)/polypropylene (b1)/4-methyl-1-pentene copolymer (3) (each layer thickness = 15/20/15 µm). The stretched film thus obtained was examined on the releasability and rigidity. The results are set forth in Table 1.

Example 3

An unstretched film of three-material five-layer type having a structure of 4-methyl-1-pentene copolymer (1) /adhesive resin (c)/polypropylene (b1)/adhesive resin (c)/4-methyl-1-pentene copolymer (1) (each layer thickness = 40/20/80/20/40 µm) was prepared by the use of a T-die extrusion molding machine. This unstretched film was examined on the stretchability.

Then, the unstretched film of three-material five-layer type was uniaxially stretched in a stretch ratio of 4 times to obtain a stretched film of 4-methyl-1-pentene copolymer (1)/adhesive resin (c)/polypropylene (b1)/adhesive resin (c)/4-methyl-1-pentene copolymer (1) (each layer thickness = 10/5/20/5/1,0 µm). The stretched film thus obtained was examined on the releasability and rigidity. The results are set forth in Table 1.

Example 4

An unstretched film of three-material five-layer type having a structure of 4-methyl-1-pentene copolymer (2) /adhesive resin (c)/polypropylene (b1)/adhesive resin (c)/4-methyl-1-pentene copolymer (2) (each layer thickness = 40/20/80/20/40 µm) was prepared by the use of a T-die extrusion molding machine. This unstretched film was examined on the stretchability.

Then, the unstretched film of three-material five-layer type was uniaxially stretched in a stretch ratio of 4 times to obtain a stretched film of 4-methyl-1-pentene copolymer (2)/adhesive resin (c)/polypropylene (b1)/adhesive resin (c)/4-methyl-1-pentene copolymer (2) (each layer thickness = 10/5/20/5/10 µm). The stretched film thus obtained was examined on the releasability and rigidity. The results are set forth in Table 1.

Example 5

An unstretched film of three-material five-layer type having a structure of 4-methyl-1-pentene copolymer (3) /adhesive resin (c)/polypropylene (b1)/adhesive resin (c)/4-methyl-1-pentene copolymer (3) (each layer thickness = 40/20/80/20/40 µm) was prepared by the use of a T-die extrusion molding machine. This unstretched film was examined on the stretchability.

Then, the unstretched film of three-material five-layer type was uniaxially stretched in a stretch ratio of 4 times to obtain a stretched film of 4-methyl-1-pentene copolymer (3)/adhesive resin (c)/polypropylene (b1)/adhesive resin (c)/4-methyl-1-pentene copolymer (3) (each layer thickness = 10/5/20/5/10 µm). The stretched film thus obtained was examined on the releasability and rigidity. The results are set forth in Table 1.

Example 6

An unstretched film of three-material five-layer type having a structure of 4-methyl-1-pentene copolymer (1) /adhesive resin (c)/polyethylene (b2)/adhesive resin (c)/4-methyl-1-pentene copolymer (1) (each layer thickness = 40/20/80/20/40 μm) was prepared by the use of a T-die extrusion molding machine. This unstretched film was examined on the stretchability.

Then, the unstretched film of three-material five-layer type was uniaxially stretched in a stretch ratio of 4 times to obtain a stretched film of 4-methyl-1-pentene copolymer (1)/adhesive resin (c)/polyethylene (b2)/adhesive resin (c) /4-methyl-1-pentene copolymer (1) (each layer thickness = 10/5/20/5/10 μm). The stretched film thus obtained was examined on the releasability and rigidity. The results are set forth in Table 1.

Example 7

An unstretched film of three-material five-layer type having a structure of 4-methyl-1-pentene copolymer (4) /adhesive resin (c)/polypropylene (b1)/adhesive resin (c)/4-methyl-1-pentene copolymer (4) (each layer thickness = 40/20/80/20/40 μm) was prepared by the use of a T-die extrusion molding machine. This unstretched film was examined on the stretchability.

Then, the unstretched film of three-material five-layer type was uniaxially stretched in a stretch ratio of 4 times to obtain a stretched film of 4-methyl-1-pentene copolymer (4)/adhesive resin (c)/polypropylene (b1)/adhesive resin (c)/4-methyl-1-pentene copolymer (4) (each layer thickness = 10/5/20/5/10 μm). The stretched film thus obtained was examined on the releasability and rigidity. The results are set forth in Table 1.

Example 8

An unstretched film of three-material five-layer type having a structure of 4-methyl-1-pentene copolymer (1) /adhesive resin (c)/polypropylene (b1)/adhesive resin (c)/4-methyl-1-pentene copolymer (1) (each layer thickness = 20/10/40/10/20 μm) was prepared by the use of a T-die extrusion molding machine. This unstretched film was examined on the stretchability.

Then, the unstretched film of three-material five-layer type was uniaxially stretched in a stretch ratio of 2 times to obtain a stretched film of 4-methyl-1-pentene copolymer (1)/adhesive resin (c)/polypropylene (b1)/adhesive resin (c)/4-methyl-1-pentene copolymer (1) (each layer thickness = 10/5/20/5/10 μm). The stretched film thus obtained was examined on the releasability and rigidity. The results are set forth in Table 1.

Table 1

| | Example 1 | Example 2 | Example 3 | Example 4 | Example 5 | Example 6 | Example 7 | Example 8 |
|---|---|---|---|---|---|---|---|---|
| Type of 4-methyl-1-pentene copolymer | (1) | (3) | (1) | (2) | (3) | (1) | (4) | (1) |
| Type of resin to be laminated | PP(b1) | PP(b1) | PP(b1) | PP(b1) | PP(b1) | PE(b2) | PP(b1) | PP(b1) |
| Presence of adhesive resin | Absent | Absent | Present | Present | Present | Present | Present | Present |
| Uniaxial stretching stretch ratio (times) | 4 | 4 | 4 | 4 | 4 | 4 | 4 | 2 |
| Stretchability (number of films with breaks) | 0／5 | 1／5 | 0／5 | 0／5 | 1／5 | 0／5 | 0／5 | 0／5 |
| Releasability | Good | Good | Good | Good | Good | Good | Good | Good |
| Rigidity (MPa) | 1700 | 2100 | 1700 | 1800 | 2100 | 1700 | 1900 | 1600 |

PP(b1) : polypropylene (b1)  PE(b2) : polyethylene (b2)

EP 1 264 685 A1

Example 9

The same unstretched film of two-material three-layer type as prepared in Example 1 was biaxially oriented in a stretch ratio of 2 times in the machine direction and a stretch ratio of 2 times in the transverse direction to obtain an oriented film of 4-methyl-1-pentene copolymer (1)/polypropylene (b1)/4-methyl-1-pentene copolymer (1) (each layer thickness = 15/20/15 μm).

The orientation was carried out by cutting the unstretched film to give a square specimen having a length of 5 cm and a width of 5 cm and biaxially orienting the specimen in a stretch ratio of 2 times in the machine direction and a stretch ratio of 2 times in the transverse direction at a temperature of 180°C and a rate of 5 m/min (the same shall apply to the following Examples 10 to 16).

The biaxial oriented film was examined on the releasability and rigidity. The results are set forth in Table 2, in which the stretchability of the unstretched film is also set forth.

In the examples, the releasability was evaluated in the following manner.

Releasability

A film was superposed on a surface of a copper foil, said surface having been subjected to black oxidation with sodium chlorite, and they were pressed under the conditions of 200°C, 40 kg and 30 minutes. Then, releasability of the film from the copper foil was examined.

Example 10

The same unstretched film of two-material three-layer type as prepared in Example 2 was biaxially oriented in a stretch ratio of 2 times in the machine direction and a stretch ratio of 2 times in the transverse direction to obtain an oriented film of 4-methyl-1-pentene copolymer (3)/polypropylene (b1)/4-methyl-1-pentene copolymer (3) (each layer thickness = 15/20/15 μm). The oriented film was examined on the releasability and rigidity. The results are set forth in Table 2, in which the stretchability of the unstretched film is also set forth.

Example 11

The same unstretched film of three-material five-layer type as prepared in Example 3 was biaxially oriented in a stretch ratio of 2 times in the machine direction and a stretch ratio of 2 times in the transverse direction to obtain an oriented film of 4-methyl-1-pentene copolymer (1)/adhesive resin (c)/polypropylene (b1)/adhesive resin (c)/4-methyl-1-pentene copolymer (1) (each layer thickness = 10/5/20/5/10 μm). The oriented film was examined on the releasability and rigidity. The results are set forth in Table 2, in which the stretchability of the unstretched film is also set forth.

Example 12

The same unstretched film of three-material five-layer type as prepared in Example 4 was biaxially oriented in a stretch ratio of 2 times in the machine direction and a stretch ratio of 2 times in the transverse direction to obtain an oriented film of 4-methyl-1-pentene copolymer (2)/adhesive resin (c)/polypropylene (b1)/adhesive resin (c)/4-methyl-1-pentene copolymer (2) (each layer thickness = 10/5/20/5/10 μm). The oriented film was examined on the releasability and rigidity. The results are set forth in Table 2, in which the stretchability of the unstretched film is also set forth.

Example 13

The same unstretched film of three-material five-layer type as prepared in Example 5 was biaxially oriented in a stretch ratio of 2 times in the machine direction and a stretch ratio of 2 times in the transverse direction to obtain an oriented film of 4-methyl-1-pentene copolymer (3)/adhesive resin (c)/polypropylene (b1)/adhesive resin (c)/4-methyl-1-pentene copolymer (3) (each layer thickness = 10/5/20/5/10 μm). The oriented film was examined on the releasability and rigidity. The results are set forth in Table 2, in which the stretchability of the unstretched film is also set forth.

Example 14

The same unstretched film of three-material five-layer type as prepared in Example 6 was biaxially oriented in a stretch ratio of 2 times in the machine direction and a stretch ratio of 2 times in the transverse direction to obtain an oriented film of 4-methyl-1-pentene copolymer (1)/adhesive resin (c)/polyethylene (b2)/adhesive resin (c)/4-methyl-1-pentene copolymer (1) (each layer thickness = 10/5/20/5/10 μm). The oriented film was examined on the releasability and rigidity. The results are set forth in Table 2.

Example 15

The same unstretched film of three-material five-layer type as prepared in Example 7 was biaxially oriented in a stretch ratio of 2 times in the machine direction and a stretch ratio of 2 times in the transverse direction to obtain an oriented film of 4-methyl-1-pentene copolymer (4)/adhesive resin (c)/polypropylene (b1)/adhesive resin (c)/4-methyl-1-pentene copolymer (4) (each layer thickness = 10/5/20/5/10 μm). The oriented film was examined on the releasability and rigidity. The results are set forth in Table 2, in which the stretchability of the unstretched film is also set forth.

Example 16

The same unstretched film of three-material five-layer type as prepared in Example 8 was biaxially oriented in a stretch ratio of 1.5 times in the machine direction and a stretch ratio of 1.5 times in the transverse direction to obtain an oriented film of 4-methyl-1-pentene copolymer (1)/adhesive resin (c)/polypropylene (b1)/adhesive resin (c)/ 4-methyl-1-pentene copolymer (1) (each layer thickness = 10/5/20/5/10 μm). The oriented film was examined on the releasability and rigidity. The results are set forth in Table 2, in which the stretchability of the unstretched film is also set forth.

Table 2

| | Example 9 | Example 10 | Example 11 | Example 12 | Example 13 | Example 14 | Example 15 | Example 16 |
|---|---|---|---|---|---|---|---|---|
| Type of 4-methyl-1-pentene copolymer | (1) | (3) | (1) | (2) | (3) | (1) | (4) | (1) |
| Type of resin to be laminated | PP(b1) | PP(b1) | PP(b1) | PP(b1) | PP(b1) | PE(b2) | PP(b1) | PP(b1) |
| Presence of adhesive resin | Absent | Absent | Present | Present | Present | Present | Present | Present |
| Biaxial orientation stretch ratio (machine direction × transverse direction) | 2 × 2 | 2 × 2 | 2 × 2 | 2 × 2 | 2 × 2 | 2 × 2 | 2 × 2 | 1.5 × 1.5 |
| Stretchability (number of films with breaks) | 0／5 | 1／5 | 0／5 | 0／5 | 1／5 | 0／5 | 0／5 | 0／5 |
| Releasability | Good | Good | Good | Good | Good | Good | Good | Good |
| Rigidity (MPa) | 1800 | 2100 | 1700 | 1900 | 2000 | 1800 | 1900 | 1700 |

PP(b1) : polypropylene (b1)    PE(b2) : polyethylene (b2)

Comparative Example 1

A two-material three-layer film of 4-methyl-1-pentene copolymer (1)/polypropylene (b1)/4-methyl-1-pentene copolymer (1) (each layer thickness = 15/20/15 µm) was prepared by the use of a T-die extrusion molding machine. This film was examined on the releasability and rigidity. The results are set forth in Table 3.

Comparative Example 2

A three-material five-layer film of 4-methyl-1-pentene copolymer (1)/adhesive resin (c)/polypropylene (b1)/ adhesive resin (c)/4-methyl-1-pentene copolymer (1) (each layer thickness = 10/5/20/5/10 µm) was prepared by the use of a T-die extrusion molding machine This three-material five-layer film was examined on the releasability and rigidity. The results are set forth in Table 3.

Comparative Example 3

A three-material five-layer film of 4-methyl-1-pentene copolymer (3)/adhesive resin (c)/polypropylene (b1)/ adhesive resin (c)/4-methyl-1-pentene copolymer (3) (each layer thickness = 10/5/20/5/10 µm) was prepared by the use of a T-die extrusion molding machine. This three-material five-layer film was examined on the releasability and rigidity. The results are set forth in Table 3.

Comparative Example 4

A single-layer film of 4-methyl-1-pentene copolymer (1) having a thickness of 200 µm was prepared by the use of a T-die extrusion molding machine. This single-layer film was examined on the stretchability. The result is set forth in Table 3.

Table 3

| | Compar. Example 1 | Compar. Example 2 | Compar. Example 3 | Compar. Example 4 |
|---|---|---|---|---|
| Type of 4-methyle-1-pentene copolymer | (1) | (1) | (3) | (1) |
| Type of resin to be laminated | PP(b1) | PP(b1) | PP(b1) | — |
| Presence of adhesive resin | Absent | Present | Present | — |
| Uniaxial stretching stretch ratio (times) | 0 | 0 | 0 | 4 |
| Stretchability (number of films with breaks) | - | - | - | 4/5 |
| Releasability | The film completely sticks to the copper foil and is not released at all. | The film completely sticks to the copper foil and is not released at all. | Although the film is partly released from the copper foil, 80 % of the film sticks to the copper foil and is not released. | — |
| Rigidity (MPa) | 1200 | 1200 | 1400 | 1400 |

**INDUSTRIAL APPLICABILITY**

The first and the second 4-methyl-1-pentene copolymer multi-layer films according to the present invention have high rigidity and excellent releasability from black oxidated copper foils and are suitable for MLB production.
In the first process for producing a 4-methyl-1-pentene copolymer multi-layer film according to the invention, a multi-layer laminate comprising a 4-methyl-1-pentene copolymer and polyethylene or polypropylene is uniaxially stretched in a specific stretch ratio. Hence, stretching unevenness and breaks hardly occur in the stretching operation, and the productivity is high.

In the second process for producing a 4-methyl-1-pentene copolymer multi-layer film according to the invention, a multi-layer laminate comprising a 4-methyl-1-pentene copolymer and polyethylene or polypropylene is biaxially oriented in a specific stretch ratio. Hence, stretching unevenness and breaks hardly occur in the stretching operation, and the productivity is high.

**Claims**

1. A 4-methyl-1-pentene copolymer multi-layer film which is a three-layer laminate comprising:

   (A) a layer comprising a 4-methyl-1-pentene copolymer (a) obtained from 4-methyl-1-pentene and an $\alpha$-olefin of 2 to 20 carbon atoms other than 4-methyl-1-pentene, and
   (B) a layer comprising polypropylene (b1) or polyethylene (b2),
   said layer (A) being provided on each surface of the layer (B),
   said multi-layer film being uniaxially stretched in a stretch ratio of not less than 2 times.

2. A 4-methyl-1-pentene copolymer multi-layer film which is a five-layer laminate comprising:

   (A) a layer comprising a 4-methyl-1-pentene copolymer (a) obtained from 4-methyl-1-pentene and an $\alpha$-olefin of 2 to 20 carbon atoms other than 4-methyl-1-pentene,
   (B) a layer comprising polypropylene (b1) or polyethylene (b2), and
   (C) a layer comprising an adhesive resin (c),
   said layer (A) being provided on each surface of the layer (B) through the layer (C),
   said multi-layer film being uniaxially stretched in a stretch ratio of not less than 2 times.

3. The 4-methyl-1-pentene copolymer multi-layer film as claimed in claim 1 or 2, wherein the 4-methyl-1-pentene copolymer (a) contains recurring units derived from 4-methyl-1-pentene in amounts of not less than 93 % by weight.

4. The 4-methyl-1-pentene copolymer multi-layer film as claimed in claim 2, wherein the adhesive resin (c) comprises poly-4-methyl-1-pentene (d) and poly-1-butene (e), and the weight ratio (d:e) of the poly-4-methyl-1-pentene (d) to the poly-1-butene (e) is in the range of 95:5 to 50:50.

5. The 4-methyl-1-pentene copolymer multi-layer film as claimed in any one of claims 1 to 4, which has a tensile modulus of not less than 1500 MPa.

6. The 4-methyl-1-pentene copolymer multi-layer film as claimed in any one of claims 1 to 5, which is a release film.

7. A 4-methyl-1-pentene copolymer multi-layer film which is a three-layer laminate comprising:

   (A) a layer comprising a 4-methyl-1-pentene copolymer (a) obtained from 4-methyl-1-pentene and an $\alpha$-olefin of 2 to 20 carbon atoms other than 4-methyl-1-pentene, and
   (B) a layer comprising polypropylene (b1) or polyethylene (b2),
   said layer (A) being provided on each surface of the layer (B),
   said multi-layer film being biaxially oriented in a stretch ratio of not less than 1.5 times in each of the machine direction and the transverse direction.

8. A 4-methyl-1-pentene copolymer multi-layer film which is a five-layer laminate comprising:

   (A) a layer comprising a 4-methyl-1-pentene copolymer (a) obtained from 4-methyl-1-pentene and an $\alpha$-olefin of 2 to 20 carbon atoms other than 4-methyl-1-pentene,
   (B) a layer comprising polypropylene (b1) or polyethylene (b2), and
   (C) a layer comprising an adhesive resin (c),
   said layer (A) being provided on each surface of the layer (B) through the layer (C),
   said multi-layer film being biaxially oriented in a stretch ratio of not less than 1.5 times in each of the machine direction and the transverse direction.

9.  The 4-methyl-1-pentene copolymer multi-layer film as claimed in claim 7 or 8, wherein the 4-methyl-1-pentene copolymer (a) contains recurring units derived from 4-methyl-1-pentene in amounts of not less than 93 % by weight.

10. The 4-methyl-1-pentene copolymer multi-layer film as claimed in claim 8, wherein the adhesive resin (c) comprises poly-4-methyl-1-pentene (d) and poly-1-butene (e), and the weight ratio (d:e) of the poly-4-methyl-1-penten (d) to the poly-1-butene (e) is in the range of 95:5 to 50:50.

11. The 4-methyl-1-pentene copolymer multi-layer film as claimed in any one of claims 7 to 10, which has a tensile modulus of not less than 1500 MPa.

12. The 4-methyl-1-pentene copolymer multi-layer film as claimed in any one of claims 7 to 11, which is a release film.

13. A process for producing a 4-methyl-1-pentene copolymer multi-layer film, comprising uniaxially stretching a three-layer laminate in a stretch ratio of not less than 2 times, said three-layer laminate comprising:

    (A) a layer comprising a 4-methyl-1-pentene copolymer (a) obtained from 4-methyl-1-pentene and an $\alpha$-olefin of 2 to 20 carbon atoms other than 4-methyl-1-pentene, and
    (B) a layer comprising polypropylene (b1) or polyethylene (b2),
    said layer (A) being provided on each surface of the layer (B).

14. A process for producing a 4-methyl-1-pentene copolymer multi-layer film, comprising uniaxially stretching a five-layer laminate in a stretch ratio of not less than 2 times, said five-layer laminate comprising:

    (A) a layer comprising a 4-methyl-1-pentene copolymer (a) obtained from 4-methyl-1-pentene and an $\alpha$-olefin of 2 to 20 carbon atoms other than 4-methyl-1-pentene,
    (B) a layer comprising polypropylene (b1) or polyethylene (b2), and
    (C) a layer comprising an adhesive resin (c),
    said layer (A) being provided on each surface of the layer (B) through the layer (C).

15. A process for producing a 4-methyl-1-pentene copolymer multi-layer film, comprising biaxially orienting a three-layer laminate in a stretch ratio of not less than 1.5 times in each of the machine direction and the transverse direction, said three-layer laminate comprising:

    (A) a layer comprising a 4-methyl-1-pentene copolymer (a) obtained from 4-methyl-1-pentene and an $\alpha$-olefin of 2 to 20 carbon atoms other than 4-methyl-1-pentene, and
    (B) a layer comprising polypropylene (b1) or polyethylene (b2),
    said layer (A) being provided on each surface of the layer (B).

16. A process for producing a 4-methyl-1-pentene copolymer multi-layer film, comprising biaxially orienting a five-layer laminate in a stretch ratio of not less than 1.5 times in each of the machine direction and the transverse direction, said five-layer laminate comprising:

    (A) a layer comprising a 4-methyl-1-pentene copolymer (a) obtained from 4-methyl-1-pentene and an $\alpha$-olefin of 2 to 20 carbon atoms other than 4-methyl-1-pentene,
    (B) a layer comprising polypropylene (b1) or polyethylene (b2), and
    (C) a layer comprising an adhesive resin (c),
    said layer (A) being provided on each surface of the layer (B) through the layer (C).

<div align="center">

**INTERNATIONAL SEARCH REPORT**

</div>

| | International application No. |
|---|---|
| | PCT/JP01/08143 |

| A. CLASSIFICATION OF SUBJECT MATTER |
|---|
| Int.Cl⁷   B32B27/32 |

According to International Patent Classification (IPC) or to both national classification and IPC

| B.  FIELDS SEARCHED |
|---|
| Minimum documentation searched (classification system followed by classification symbols)<br>     Int.Cl⁷   B32B1/00-35/00 |

Documentation searched other than minimum documentation to the extent that such documents are included in the fields searched
     Jitsuyo Shinan Koho          1926-1996      Toroku Jitsuyo Shinan Koho  1994-2001
     Kokai Jitsuyo Shinan Koho   1971-2001      Jitsuyo Shinan Toroku Koho  1996-2001

Electronic data base consulted during the international search (name of data base and, where practicable, search terms used)

| C.  DOCUMENTS CONSIDERED TO BE RELEVANT | | |
|---|---|---|
| Category* | Citation of document, with indication, where appropriate, of the relevant passages | Relevant to claim No. |
| X | JP 50-98582 A (Matsushita Electric Ind. Co., Ltd.), 05 August, 1975 (05.08.75), Full text   (Family: none) | 7-9,11,15,16 |
| Y | | 10 |
| X | JP 7-165940 A (Riken Vinyl Industry Co., Ltd.), 27 June, 1995 (27.06.95), Claims; working example 3; Par. No. [0009] | 7-9,11,15,16 |
| Y | (Family: none) | 10 |
| Y | EP 943427 A (Mitsui Chem. Inc.), 22 September, 1999 (22.09.99), Full text & JP 11-198314 A | 10 |
| A | EP 376681 A (Mitsui Petrochem. Ind. Co., Ltd.), 04 July, 1990 (04.07.90), Full text & JP 2-175247 A      & US 5080979 A | 1-16 |

☐ Further documents are listed in the continuation of Box C.      ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>     05 December, 2001 (05.12.01) | Date of mailing of the international search report<br>     18 December, 2001 (18.12.01) |
|---|---|
| Name and mailing address of the ISA/<br>     Japanese Patent Office | Authorized officer |
| Facsimile No. | Telephone No. |

Form PCT/ISA/210 (second sheet) (July 1992)